(19) Europäisches Patentamt
European Patent Office
Office européen des brevets

(11) **EP 2 825 923 B1**

(12) **EUROPÄISCHE PATENTSCHRIFT**

(45) Veröffentlichungstag und Bekanntmachung des Hinweises auf die Patenterteilung:
**18.01.2017 Patentblatt 2017/03**

(21) Anmeldenummer: **12722125.7**

(22) Anmeldetag: **15.05.2012**

(51) Int Cl.:
*G05B 17/02* *(2006.01)*     *G06Q 10/04* *(2012.01)*
*G06Q 10/06* *(2012.01)*

(86) Internationale Anmeldenummer:
**PCT/EP2012/059015**

(87) Internationale Veröffentlichungsnummer:
**WO 2013/170884 (21.11.2013 Gazette 2013/47)**

(54) **VERFAHREN ZUM ERMITTELN UND OPTIMIEREN EINES ENERGIEVERBRAUCHS EINES PRODUKTIONSSYSTEMS**

METHOD FOR DETERMINING AND OPTIMISING THE ENERGY CONSUMPTION OF A PRODUCTION SYSTEM

PROCÉDÉ POUR DÉTERMINER ET OPTIMISER LA CONSOMMATION D'ÉNERGIE D'UN SYSTÈME DE PRODUCTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**21.01.2015 Patentblatt 2015/04**

(73) Patentinhaber: **Siemens Aktiengesellschaft 80333 München (DE)**

(72) Erfinder:
• **HASSEL, Jörg**
  **91058 Erlangen (DE)**
• **MOHSEN, Amjad**
  **91058 Erlangen (DE)**
• **REINSCHKE, Johannes**
  **90425 Nürnberg (DE)**

(56) Entgegenhaltungen:
**DE-A1- 19 908 317     DE-U1- 29 707 245**

## Beschreibung

Die vorliegende Erfindung betrifft ein Verfahren zum Ermitteln eines Energieverbrauchs eines Produktionssystems. Überdies betrifft die vorliegende Erfindung ein Verfahren zum Betreiben eines Produktionssystems.

Produktionssysteme werden momentan während einer sehr frühen Designphase simuliert, um den Durchsatz und die Effizienz zu erhöhen. Zu diesem Zweck werden beispielsweise Simulationsprogramme wie Plant Simulation von Technomatrix/Siemens verwendet. Solche Programme entwickeln ein Modell für die geplante Anlage bzw. das Produktionssystem, mit dem ein schnelles Simulieren und Testen von verschiedenen Regelstrategien ermöglicht wird. Die Ergebnisse der Simulation werden dazu genutzt, um das Layout des Produktionssystems und Regelstrategien während des Entwurfs des Produktionssystems herauszufinden.

Mit den momentan verwendeten Simulationsprogrammen kann ein lastabhängiger Energieverbrauch allerdings nicht ermittelt werden. Während des Entwurfs des Produktionssystems wird der Energieverbrauch "von Hand" abgeschätzt, was üblicherweise zu einer beträchtlichen Überschätzung des Energieverbrauchs führt. Darüber hinaus ist eine Optimierung des Betriebs des Produktionssystems, um den Energieverbrauch zu reduzieren mit den zuvor genannten Programmen nicht möglich. Insbesondere im Hinblick auf Umweltschutz und steigende Energiepreise ist dies aber ein wichtiger Aspekt.

In dem Artikel "Planung energieeffizienter Produktionssysteme" von N. Weinert, veröffentlicht in ZWF, Jahrg. 105, 2010, ist beschrieben, dass bei einem Produktionssystem unterschiedliche Betriebszustände, wie der Hochlauf, der Warmlauf, Wartezustände, der Bearbeitungs- bzw. Prozesszustand oder ein Abschaltvorgang auftreten können. Diese Betriebszustände, die einen unterschiedlichen Energiebedarf aufweisen, werden entsprechenden Blöcken zugeordnet, die modelliert und simuliert werden.

Aus der DE 297 07 245 U1 ist bereits eine Regelung eines Förderbands für Massengut im industriellen Einsatz bekannt, bei der eine Einsparung des Energieverbrauchs erreicht wird, indem anhand eines vorgegebenen Lastprofils der Energiebedarf berechnet wird und eine Optimierung beispielsweise anhand der Anpassung der Geschwindigkeit des Förderbands erreicht wird. Es ist Aufgabe der vorliegenden Erfindung, einen Weg aufzuzeigen, wie ein Produktionssystem energieeffizienter geplant und betrieben werden kann.

Diese Aufgabe wird durch ein Verfahren gemäß Patentanspruch 1 und durch ein Verfahren gemäß Patentanspruch 9 gelöst. Vorteilhafte Weiterbildungen der vorliegenden Erfindung sind in den Unteransprüchen angegeben.

Das erfindungsgemäße Verfahren zum Bestimmen eines Energieverbrauchs eines Produktionssystems umfasst die folgenden Schritte:

a) Bestimmen eines Lastprofils des Produktionssystems in Abhängigkeit von Betriebsgrößen des Produktionssystems, welche eine Geschwindigkeit, eine Beschleunigung, ein Grundgewicht des Produktionssystems und/oder ein Gewicht der Last beschreiben mit einer Lastberechnungseinrichtung,

b) Abschätzen eines Energiebedarfs des Produktionssystems anhand des bestimmten Lastprofils und eines elektromechanischen Modells des Produktionssystems mit einer Energieberechnungseinrichtung,

c) Bestimmen eines Energiemodells des Produktionssystems anhand des abgeschätzten Energiebedarfs, wobei zumindest eine der Betriebsgrößen als konstant angenommen wird und in Abhängigkeit von den nicht als konstant angenommenen Betriebsgrößen eine Leistungstabelle bestimmt wird und

d) Bestimmen des Energieverbrauchs des Produktionssystems mit der Lastberechnungseinrichtung in Abhängigkeit von dem Energiemodell und einer mit dem Produktionssystem transportierten und/oder bearbeiteten Last.

Mit dem erfindungsgemäßen Verfahren kann in vorteilhafter Weise der Energieverbrauch des Produktionssystems abgeschätzt werden. Unter dem Begriff Produktionssystem soll im Folgenden jede Anlage, Produktionsanlage oder dergleichen verstanden werden. Insbesondere kann das Produktionssystem ein Förderband umfassen, auf dem eine Last bewegt bzw. transportiert wird. Zunächst wird ein zeitabhängiges Lastprofil des Produktionssystems mit der Lastberechnungseinrichtung bestimmt. Die Lastberechnungseinrichtung kann eine Recheneinrichtung, wie einen Computer, ein Mikroprozessor oder dergleichen, umfassen, auf dem ein Simulationsprogramm für ein Produktionssystem, wie z. B. Plant Simulation, zum Ablauf gebracht wird. Dabei werden realistische Annahmen bezüglich des Durchsatzes zugrunde gelegt. Anschließend wird ein Energiebedarf des Produktionssystems mit einer Energieberechnungseinrichtung ermittelt. Die Energieberechnungseinrichtung kann eine Recheneinrichtung, wie einen Computer, ein Mikroprozessor oder dergleichen, umfassen, auf dem ein Programm zum Ablauf gebracht wird, mit dem die Leistung eines Systems abgeschätzt werden kann. Ein solches Programm kann beispielsweise das Programm SIZER der Firma Siemens sein.

Bevorzugt wird das Produktionssystem in einzelne Bereiche unterteilt und das Verfahren wird für jeden der Bereiche durchgeführt. Somit kann der Energieverbrauch besonders exakt in Abhängigkeit von der Ausgestaltung des Produktionssystems bestimmt werden. Dabei können Bereiche des Produktionssystems, die gleich sind, nur einmal berechnet werden. Damit kann der Energieverbrauch des Produktionssystems besonders effizient bestimmt werden.

In einer Ausgestaltung wird in Schritt a) das Lastprofil in Abhängigkeit von Betriebsgrößen des Produktionssystems, welche eine Geschwindigkeit, eine Beschleunigung, ein Grundgewicht des Produktionssystems und/oder ein Gewicht der Last beschreiben, bestimmt. Das Lastprofil wird dabei insbesondere für jeden Bereich des Produktionssystems ermittelt. Dabei werden die Geschwindigkeit bzw. die Beschleunigung des Produktionssystems oder eines Teils des Produktionssystems und das Gewicht der mit dem Produktionssystem transportierten Güter berücksichtigt. Im Anschluss kann das Lastprofil analysiert und gegebenenfalls in ein anderes Datenformat überschrieben werden. Beim Übertragen in ein anderes Datenformat kann die Datei, die Informationen über das Lastprofil umfasst, auch in mehrere Einzeldateien unterteilt werden. Dies ist insbesondere günstig, wenn das Lastprofil über einen längeren Zeitraum, beispielsweise einen Tag, ermittelt wurde.

Bevorzugt wird in Schritt b) das elektromechanische Modell in Abhängigkeit von Kenngrößen von Antriebseinrichtungen des Produktionssystems und den Abmessungen des Produktionssystems bestimmt. Das elektromechanische Modell kann diejenigen Parameter umfassen, mit denen das elektromechanische System des Produktionssystems ausreichend beschrieben werden kann. Das elektromechanische Modell kann Informationen zu den Typen der verwendeten elektrischen Maschinen, Startern, Wandlern, Ein-/Ausgabeelementen oder dergleichen umfassen. Zudem kann das elektromechanische Modell Informationen über die Länge und Breite der einzelnen Bereiche des Produktionssystems umfassen.

In einer weiteren Ausgestaltung wird in Schritt c) das Energiemodell in Abhängigkeit von den Betriebsgrößen des Produktionssystems bestimmt. Dazu wird bevorzugt eine mathematische Gleichung aufgestellt, mit der die benötigte Leistung bzw. Energie des Produktionssystems oder Bereichen des Produktionssystems modelliert werden kann. Zusätzlich kann ein mathematisches Modell entwickelt werden, in dem für jede Variable in der mathematischen Gleichung der Anteil an der insgesamt verbrauchten Leistung bestimmt wird. Das Energiemodell kann in allgemeiner Form mit folgender Gleichung dargestellt werden:

$$P_i = K_1 \cdot V_{i1}^{j1} + K_2 \cdot V_{i2}^{j2} + ... + K_n \cdot V_{in}^{jn}$$

Dabei beschreiben die Variablen $V_{i1}$ bis $V_{in}$ die Geschwindigkeit bzw. die Beschleunigung der einzelnen Bereiche des Produktionssystems und die Last, die mit den jeweiligen Bereichen des Produktionssystems transportiert wird. Diese Variablen beschreiben den Energieverbrauch in dem physikalischen System. j ist eine reelle Zahl, mit der die Ordnung der jeweiligen Variablen angegeben wird. Zwischen den Variablen, beispielsweise der Geschwindigkeit und der Beschleunigung, kann ein Zusammenhang vorliegen. Die Konstanten $K_1$ bis $K_n$ beschreiben die sogenannten Leistungskonstanten.

Das mit der Lastberechnungseinrichtung bestimmte Lastprofil kann in m Einzeldateien unterteilt werden. Die Einzeldateien können der Reihen nach der Energieberechnungseinrichtung zugeführt werden. Zusammen mit den Informationen über das elektromechanischen Systems kann mit der Energieberechnungseinrichtung für jeden Bereich des Produktionssystems die benötigt Energie bzw. Leistung abgeschätzt werden. Anhand der m Schätzwerte für die Leistung kann die folgende Matrixgleichung aufgestellt werden:

$$\begin{bmatrix} P_1 \\ P_2 \\ \vdots \\ P_m \end{bmatrix} = \begin{bmatrix} V_{11}^{j1} & V_{12}^{j2} & \cdots & V_{1n}^{jn} \\ V_{21}^{j1} & V_{22}^{j2} & \cdots & V_{2n}^{jn} \\ \vdots & & & \\ V_{m1}^{j1} & V_{m2}^{j2} & \cdots & V_{mn}^{jn} \end{bmatrix} * \begin{bmatrix} K_1 \\ K_2 \\ \vdots \\ K_n \end{bmatrix}$$

Die Matrixgleichung kann nach den Leistungsfaktoren $K_1$ bis $K_n$ aufgelöst werden, um diese zu ermitteln.

Bevorzugt wird in Schritt c) zumindest eine der der Betriebsgrößen als konstant angenommen und in Abhängigkeit von den nicht als konstant angenommenen Betriebsgrößen wird eine Leistungstabelle bestimmt. Wenn die Geschwindigkeit des Produktionssystems für eine bestimmte Zeitdauer konstant ist, nimmt die Beschleunigung des Produktionssystems den Wert Null an. Damit kann das Energiemodell mit der Energieberechnungseinrichtung nur noch in Abhängigkeit von dem Gewicht des Produktionssystems und/oder der bewegten Last ermittelt werden. Wenn die Variablen in der Gleichung für das Energiemodell für einen bestimmten Zeitraum als konstant angenommen werden, kann die Gleichung in Abhängigkeit von einer Variablen umgeschrieben werden:

$$P_i = C_1 \cdot V_{im}^{jm} + C_2$$

Dabei sind $C_1$ und $C_2$ Konstanten, die mit der Energieberechnungseinrichtung ermittelt werden können. Dazu können die Konstanten für jeden möglichen Wert der Variablen abgeschätzt werden. Die Ergebnisse der Abschätzung können in einer oder mehreren Leistungstabellen für jeden Bereich des Produktionssystems gespeichert werden.

In einer Ausführungsform wird zumindest eine der Betriebsgrößen des Produktionssystems anhand von Messungen ermittelt. Zu diesem Zweck können physikalische Messungen an dem Produktionssystem im Betrieb durchgeführt werden. Mit den Daten der Messungen können die Betriebsgrößen besonders genau ermittelt werden. Auf Grundlage dieser Messungen kann der Energieverbrauch des Produktionssystems exakt bestimmt werden.

Bevorzugt wird in Schritt d) der Energieverbrauch des Produktionssystems in Abhängigkeit von dem Energiemodell oder der Leistungstabelle bestimmt. Die Lastberechnungseinrichtung werden die Leistungstabellen und die Energiemodell zugeführt. Anstelle des Energiemodells können der Lastberechnungseinrichtung auch die Leistungskonstanten zugeführt werden. Mit den Leistungstabellen und/oder dem Energiemodell kann mit der Lastberechnungseinrichtung der Energieverbrauch des Produktionssystems dynamische in Abhängigkeit von einer zeitlich variablen Last, die mit dem Produktionssystem befördert wird, ermittelt werden. Damit wird es ermöglicht, die momentane Leistung, die durchschnittliche Leistung und die Energie zu berechnen. Die durchschnittliche Leistung kann für ein vorgegebenes Zeitintervall, beispielsweise eine Sekunde, berechnet werden:

$$P_{avg} = \frac{\sum\limits_{i=n_0}^{n_1} P_i \cdot T_i}{\sum\limits_{i=n_0}^{n} T_i}$$

$$E = \sum\limits_{i=n_0}^{n_1} P_i \cdot T_i$$

Beim Simulieren des Produktionssystems berechnet die Lastberechnungseinrichtung anhand der Betriebsgrößen den Energieverbrauch des Produktionssystems. Die durchschnittliche Leistung und die Energie werden für n Zeitintervalle berechnet.

Damit kann eine einfache Berechnung des Energieverbrauchs des Produktionssystems ermöglicht werden, bei der weinig Ressourcen benötigt werden, um das Energiemodell in einem Speicher der Lastberechnungseinrichtung zu speichern. Die Lastberechnungseinrichtung wird durch die zusätzliche Berechnung des Energieverbrauchs in Bezug auf die Rechenleistung nicht negativ beeinflusst. Zudem kann der Energieverbrauch des Produktionssystems schnell und zuverlässig ermittelt werden.

Weiterhin ist es vorteilhaft, wenn in Schritt d) zum Bestimmen des Energieverbrauchs zumindest eine der Betriebsgrößen an zumindest zwei aufeinanderfolgenden Zeitpunkten untersucht wird. Mit der Lastberechnungseinrichtung kann beispielsweise die Geschwindigkeit des Produktionssystems zu zwei aufeinander folgenden Zeitpunkten berücksichtigt werden, um den Energieverbrauch des Produktionssystems zu bestimmen. Wenn sich die Geschwindigkeit bei zumindest zwei aufeinanderfolgenden Zeitpunkten nicht ändert, können die Werte für die Last aus der Leistungstabelle für die jeweiligen Bereiche des Produktionssystems herangezogen werden, um den Energieverbrauch zu bestimmen. Wenn sich die Geschwindigkeit bei zumindest zwei aufeinanderfolgenden Zeitpunkten ändert, kann das Energiemodell zur Berechnung des Energieverbrauchs genutzt werden. Somit kann ein hybrider Ansatz bereitgestellt werden, um den Energieverbrauch des Produktionssystems zu ermitteln. Es kann schätzungsweise davon ausgegangen werden, dass in 70% der Fälle die Leistungstabellen zur Berechnung des Energieverbrauchs herangezogen werden. Somit ist der zusätzliche Bedarf an Ressourcen, der durch die Speicherung der Leistungstabellen belegt wird, begründet. Des Weiteren kann der Energieverbrauch zuverlässiger bestimmt werden.

Für den Fall, dass für ein geplantes Produktionssystem oder Bereiche davon, der Energieverbrauch mit der Lastberechnungseinrichtung nicht bestimmt werden kann, wird das Verfahren bzw. die Simulation angehalten und eine entsprechende Nachricht ausgegeben. Zudem kann durch eine Bedieneingabe auf die Energieberechnungseinrichtung zuzugreifen werden, wodurch mit der Energieberechnungseinrichtung die fehlenden Variablen bzw. Parameter für das Energiemodell oder die Leistungstabelle ermittelt werden können.

Bei dem erfindungsgemäßen Verfahren zum Betreiben eines Produktionssystems wird das Produktionssystem in Abhängigkeit von dem Energieverbrauch betrieben, der mit dem zuvor beschriebenen Verfahren bestimmt wurde. Dabei kann das Produktionssystem mit der Lastberechnungseinrichtung angesteuert werden. Somit kann das Produktionssystem besonderes energieeffizient betrieben werden. Beim Simulieren des Produktionssystems berechnet die Lastberechnungseinrichtung anhand der Betriebsgrößen den Energieverbrauch des Produktionssystems. Die durchschnittliche Leistung und die Energie werden für n Zeitintervalle berechnet.

Die vorliegende Erfindung wird nun anhand der beigefügten Zeichnungen näher erläutert. Dabei zeigen:

FIG 1    eine schematische Darstellung eines Produktionssystems;

FIG 2    eine schematische Darstellung zur Verdeutlichung eines Verfahrens zum Bestimmen eines Energieverbrauchs des Produktionssystems; und

FIG 3    eine schematische Darstellung zur Verdeutlichung des Verfahrens zum Bestimmen des Energieverbrauchs des Produktionssystems in einer weiteren Ausführungsform.

Die nachfolgend näher geschilderten Ausführungsbeispiele stellen bevorzugte Ausführungsformen der vorliegenden Erfindung dar.

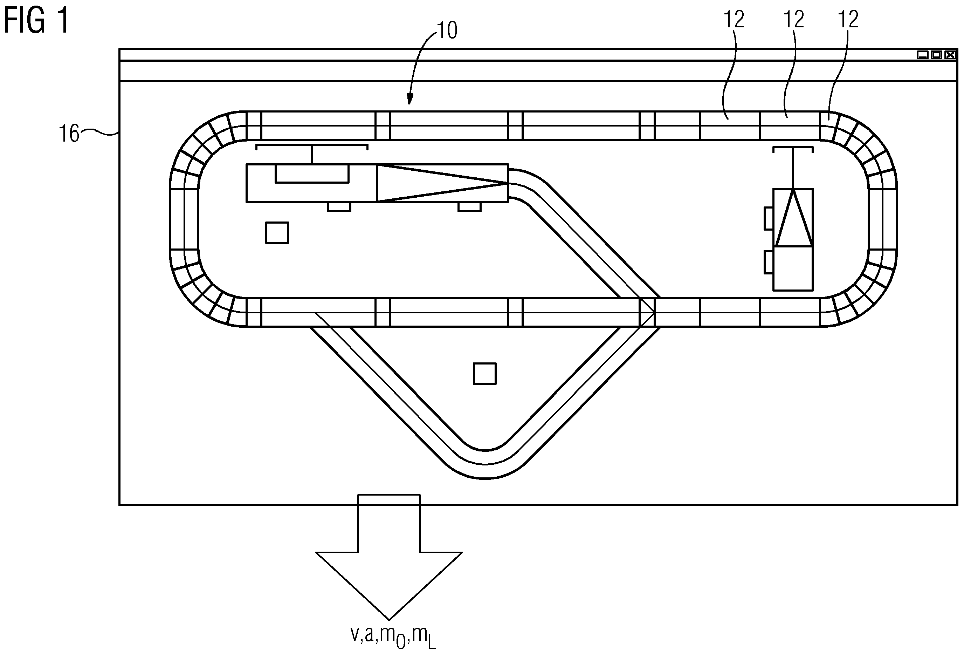

FIG 1 zeigt eine schematische Darstellung eines Produktionssystems 10. Im hier dargestellten Ausführungsbeispiel ist das Produktionssystems 10 eine Gepäckförderanlage eines Flughafens. Um die Durchsatz des Produktionssystems 10 berechnen zu können, wird eine Lastberechnungseinrichtung 16 verwendet. Die Lastberechnungseinrichtung 16 kann durch ein entsprechendes Simulationsprogramm bereitgestellt werden, das auf einem Computer, einem Mikroprozessor, einem ASIC oder dergleichen zum Ablauf gebracht wird. Als Simulationsprogramm kann beispielsweise das Programm Plant Simulation verwendet werden.

Um die Produktionssystem 10 berechnen bzw. simulieren zu können, wird das Produktionssystem 10 in mehrere Bereiche 12 bzw. Abschnitte unterteilt. Die einzelnen Bereiche 12 können dabei unterschiedliche geometrische Abmessungen aufweisen. Jedem der Bereiche 12 des Produktionssystems 10 kann eine Geschwindigkeit bzw. eine Beschleunigung des Bands der Gepäckförderanlage zugeordnet werden. Zudem kann jedem Bereich 12 eine Länge, eine Breite und eine geometrische Formgebung zugeordnet werden.

Mit der Lastberechnungseinrichtung 16 kann ein Lastprofil 18 des Produktionssystems 10 ermittelt werden. Das Lastprofil 18 wird in Abhängigkeit von Betriebsgrößen des Produktionssystems 10, welche eine Geschwindigkeit v, eine Beschleunigung a, ein Grundgewicht $m_0$ des Produktionssystems und/oder ein Gewicht $m_L$ einer mit dem Produktionssystem bewegten Last umfassen, bestimmt.

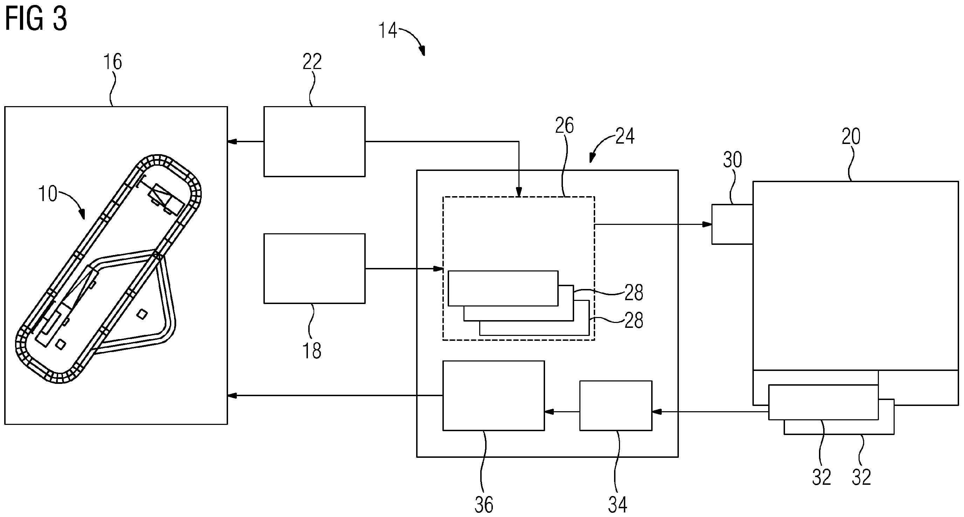

FIG 3 zeigt eine weitere Darstellung 14, die das Verfahren zum Bestimmen eines Energieverbrauchs des Produktionssystems 10 verdeutlicht. Zur Durchführung des Verfahrens wird die zuvor beschriebene Lastberechnungseinrichtung 16 benötigt, mit der das Lastprofil 18 des Produktionssystems 10 ermittelt wird. Das Lastprofil 18 kann beispielsweise für einen Tag (86400 Sekunden) ermittelt werden. Dabei können für vorgegebene Zeitintervalle, z. B. eine Sekunde, jeweils die Betriebsgrößen der einzelnen Bereiche 12 des Produktionssystems 10 ermittelt werden.

Darüber hinaus wird zur Durchführung des Verfahrens eine Energieberechnungseinrichtung 20 benötigt. Die Energieberechnungseinrichtung 20 kann durch einen ein entsprechendes Programm bereitgestellt werden, das auf einem Computer, einem Mikroprozessor, einem ASIC oder dergleichen zum Ablauf gebracht wird. Als Programm kann beispielsweise das Programm SIZER verwendet werden.

Für das Produktionssystem 10 ist ein elektromechanisches Modell 22 hinterlegt. Dazu sind bevorzugt Informationen über die Komponenten des Produktionssystems 10 für jeden Bereich 12 des Produktionssystems 10 in einer Tabelle gespeichert. Das elektromechanische Modell 22 kann technische, elektrische und/oder geometrische Kenngrößen der elektrischen Antriebe, Umrichter, Starter oder dergleichen umfassen. Diese Informationen können durch physikalische Messungen ermittelt werden. Überdies kann das elektromechanische Modell 22 Informationen über die Abmessungen der einzelnen Bereiche 12 des Produktionssystems 10 umfassen. So können die Länge, die Breite und gegebenenfalls einer räumlichen Anordnung des Gepäckbands gespeichert sein. Das elektromechanische Modell 22 wird als Referenz genutzt. Zum einem werden die Daten des elektromechanischen Modells 22 der Lastberechnungseinrichtung 16 zugeführt, zum anderen werden die Daten des elektromechanischen Modells 22 einer Datenberechnungseinrichtung 24 zugeführt.

Die Datenberechnungseinrichtung 24 kann durch eine Recheneinrichtung bereitgestellt werden, auf dem ein Programm wie Matlab oder C zu Ablauf gebracht wird. Mit der Datenberechnungseinrichtung 24 wird eine Parameterdatei 26 erzeugt, die von der Energieberechnungseinrichtung 20 verarbeitet werden kann. Diese Parameterdatei 26 wird von der Datenberechnungseinrichtung 24 anhand des elektromechanischen Modells 22 bestimmt. Dabei kann eine Parameterdatei 26 für jeden Bereich 12 des Produktionssystems 10 vorliegen. Zudem empfängt die Datenberechnungseinrichtung 24 die Daten des Lastprofils 18 und unterteilt diese in mehrere Einzeldateien 28, wobei jede Einzeldatei 28 einem Bereich 12 des Produktionssystems 10 zugeordnet ist.

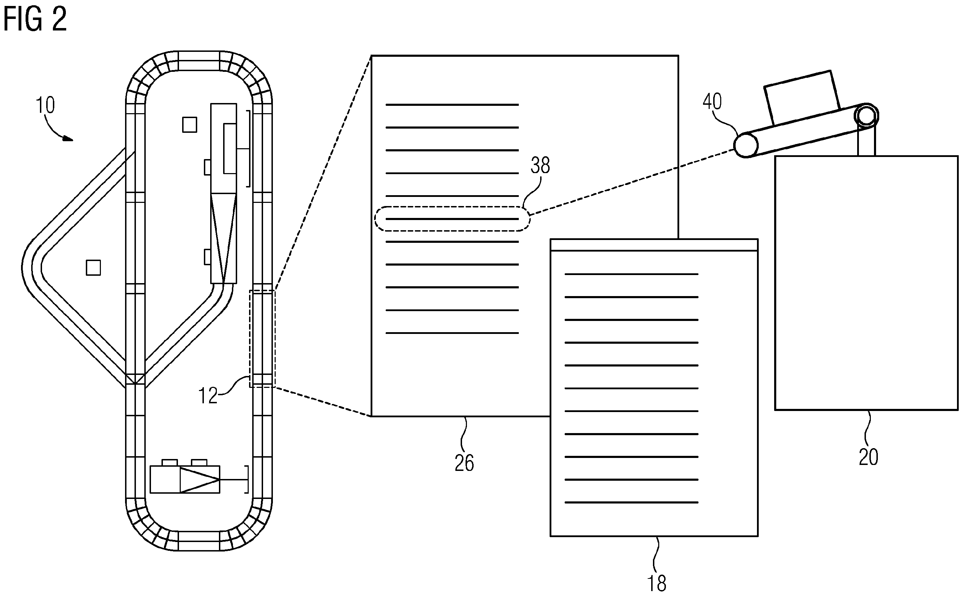

FIG 2 zeigt, das einem Bereich 12 des Produktionssystems 10 eine Parameterdatei 26 zugeordnet ist. Die Parameterdatei 26 umfasst mehrere Zeilen bzw. Einträge. Dabei ist ein Eintrag 38 dem Durchmesser einer Antriebsrolle 40 des Produktionssystems 10 in dem Bereich 12 zugeordnet.

Um den Energiebedarf der einzelnen Bereiche 12 des Produktionssystems 10 zu bestimmen, wird die Energieberechnungseinrichtung 20 wiederholt aufgerufen. Dabei wird die gleiche Parameterdatei 26 verwendet, aber bei jedem Programmaufruf wird eine neue Einzeldatei 28 bereitgestellt, solange bis alle Einzeldateien 28 mit der Energieberechnungseinrichtung 20 verarbeitet sind. Um mit der Datenberechnungseinrichtung 24 einen Programmaufruf der Energieberechnungseinrichtung 20 zu ermöglichen, ist eine Schnittstelle 30 vorgesehen.

Nach jedem Programmaufruf werden mit der Energieberechnungseinrichtung 20 Ausgabedateien 32 erzeugt. Diese Ausgabedateien 32 umfassen eine Information über den Leistungs- bzw. Energieverbrauch in Abhängigkeit dem elektromechanischen Modell 22 und dem Lastprofil 18. Die Ausgabedateien 32 werden an die Datenberechnungseinrichtung 24, dort in dem Block 34 analysiert und optimiert und als Energiemodell 36 gespeichert. Dieser Prozess wird für alle Bereiche 12 des Produktionssystems 10 wiederholt.

Im Anschluss wird das Energiemodell 36 für jeden Bereich 12 des Produktionssystems 10 ermittelt. Dazu werden zunächst die Betriebsgrößen, die den Energieverbrauch des Produktionssystems 10 beeinflussen, gemäß der nachfolgenden Gleichung spezifiziert:

$$P_1 = \eta_1 \cdot (m_0 + m_{Li}) \cdot a_i \cdot v_i + \eta_2 \cdot (m_0 + m_{Li}) \cdot v_i^2$$
$$= \eta_1 \cdot m_0 \cdot a_i \cdot v_i + \eta_1 \cdot m_{Li} \cdot a_i \cdot v_i + \eta_2 \cdot m_0 \cdot v_i^2 + \eta_2 \quad \cdot m_{Li} \cdot v_i^2$$
$$= K_1 \cdot a_1 \cdot v_1 + K_2 \cdot m_{Li} * a_1 \cdot v_1 + K_3 + v_i^2 + K_4 \cdot m_{Li} \cdot v_i^2$$

Dabei beschreiben die Konstanten $K_1$ bis $K_4$ dies sogenannten Leistungskonstanten für jeden Bereich 12 des Produktionssystems 10. Um die Leistungskonstanten $K_1$ bis $K_4$ berechnen zu können das mathematische Modell auch als Matrixgleichung dargestellt werden:

$$\begin{bmatrix} \overline{P_1} \\ \overline{P_2} \\ \vdots \\ \overline{P_N} \end{bmatrix} = \begin{bmatrix} \overline{a_1 \cdot v_1} & \overline{m_{L1} \cdot a_1 \cdot v_1} & \overline{v_1^2} & \overline{m_{L1} \cdot v_1^2} \\ \overline{a_2 \cdot v_2} & \overline{m_{L2} \cdot a_2 \cdot v_2} & \overline{v_2^2} & \overline{m_{L2} \cdot v_2^2} \\ \vdots & \vdots & \vdots & \vdots \\ \overline{a_N \cdot v_N} & \overline{m_{Ln} \cdot a_n \cdot v_n} & \overline{v_N^2} & \overline{m_{LN} \cdot v_N^2} \end{bmatrix} \cdot \begin{bmatrix} K_1 \\ K_2 \\ K_3 \\ K_4 \end{bmatrix}$$

Dabei repräsentiert der Index N in den obigen Gleichungen die Anzahl der Einzeldateien 28, die der Energieberechnungseinrichtung 20 zugeführt werden. Um die Leistungskonstanten $K_1$ bis $K_4$ zu berechnen, werden die N Schätzwerte des Energiebedarfs, die mit der Energieberechnungseinrichtung 20 ermittelt wurden, dazu verwendet, um die Matrixgleichung zu lösen.

Zusätzlich wird für jeden Bereich 12 der Produktionssystems 10 eine Leistungstabelle ermittelt. Zu diesem Zweck wird eine der Betriebsgrößen als konstant angenommen. Beispielsweise wird die Geschwindigkeit v als konstant angenommen und das Gewicht $m_L$ der Last bestimmt. Alternativ zu den Leistungstabellen kann eine vereinfachte Gleichung bereitgestellt werden:

$$P_i = C_1 \cdot (m_0 + m_L) + C_2$$

In einem letzten Schritt wird die Lastberechnungseinrichtung 16 erweitert, um mit ihr den Energie- bzw. Leistungsverbrauch des Produktionssystems 10 für eine zeitlich variable Last ermitteln zu können. Wenn die Berechnung bzw. Simulation gestartet wird, berechnet die Lastberechnungseinrichtung 16 den aktuellen Energie- bzw. Leistungsverbrauch für jeden Bereich 12 des Produktionssystems 10. Zu diesem Zweck werden die Betriebsgrößen des Produktionssystems 10 verwendet. Dabei wird die Geschwindigkeit v eines Bereichs 12 des Produktionssystems 10 zu aufeinanderfolgenden Zeitpunkten miteinander verglichen. Wenn sich die Geschwindigkeit v nicht ändert, wird anhand der Leistungstabellen oder der vereinfachten Gleichung der Energieverbrauch des Produktionssystems 10 in Abhängigkeit von dem Gewicht $m_L$ der zeitlich variablen Last ermittelt. Wenn sich die Geschwindigkeit v ändert, wird der Energieverbrauch anhand der mathematischen Gleichung oder der Matrixgleichung ermittelt.

Beispielsweise ist das Gepäckfördersystem zunächst in einem Ruhezustand und bewegt sich mit der minimalen Geschwindigkeit v von 0,3 m/s. Wenn ein Gepäckstück eintrifft, wird die Geschwindigkeit v des Gepäckfördersystems beschleunigt, bis es die Maximalgeschwindigkeit von beispielsweise 2 m/s erreicht. Die Beschleunigung a des Gepäckfördersystems kann dabei vorgegeben sein. Während der Beschleunigung sind die Geschwindigkeit v, die Beschleunigung a, die Masse $m_0$ und das Gewicht $m_L$ der Last Variablen. In diesem Fall wird die mathematische Gleichung verwendet, um den Energieverbrauch des Gepäckfördersystems bzw. des Produktionssystems 10 zu ermitteln. Wenn das Gepäckfördersystem allerdings die maximale Geschwindigkeit v erreicht hat, ist die einzige Variable das Gesamtgewicht ($m_0 + m_L$). In diesem Fall werden die Leistungstabellen herangezogen, um den Energieverbrauch in Abhängigkeit von dem momentanen Gesamtgewicht zu ermitteln.

Im Anschluss daran, wenn kein Gepäckstück transportiert wird und das Gesamtgewicht den Wert Null annimmt, wird mit der Lastberechnungseinrichtung 16 ein Signal ausgegeben, wodurch die Geschwindigkeit v des Produktionssystems 10 in Schritten reduziert wird. Bis zum Erreichen der Minimalgeschwindigkeit wird die mathematische Gleichung herangezogen, um den momentanen Energieverbrauch zu bestimmen.

Wenn beispielsweise die Anzahl der Gepäckstücke und somit die Gesamtlast auf den einzelnen Bereichen 12 verändert wird, kann es der Fall sein, dass mit der Lastberechnungseinrichtung 16 der Energieverbrauch nicht mehr ermittelt werden kann. In diesem Fall wird eine komplette Beschreibung des Lastprofils 18 ausgegeben. Die Energieberechnungseinrichtung 20 wird nochmals aufgerufen, um die Leistungstabellen zu aktualisieren. Die Lastberechnungseinrichtung 16 kann die aktualisierten Leistungstabellen nutzen, um das Produktionssystem zu betreiben.

Bezugszeichenliste

| | |
|---|---|
| 10 | Produktionssystem |
| 12 | Bereich |
| 14 | Darstellung |
| 16 | Lastberechnungseinrichtung |
| 18 | Lastprofil |
| 20 | Energieberechnungseinrichtung |
| 22 | elektromechanisches Modell |
| 24 | Datenberechnungseinrichtung |
| 26 | Parameterdatei |
| 28 | Einzeldatei |
| 30 | Schnittstelle |
| 32 | Ausgabedatei |
| 34 | Block |
| 36 | Energiemodell |
| 38 | Eintrag |
| 40 | Antriebsrolle |
| a | Beschleunigung |
| $m_0$ | Grundgewicht |
| $m_L$ | Gewicht |
| v | Geschwindigkeit |

**Patentansprüche**

1.  Verfahren zum Bestimmen eines Energieverbrauchs eines Produktionssystems (10) mit den Schritten:

    a) Bestimmen eines Lastprofils (18) des Produktionssystems (10) in Abhängigkeit von Betriebsgrößen des Produktionssystems, welche eine Geschwindigkeit, eine Beschleunigung, ein Grundgewicht des Produktionssystems und/oder ein Gewicht der Last beschreiben mit einer Lastberechnungseinrichtung (16),
    b) Abschätzen eines Energiebedarfs des Produktionssystems (10) anhand des bestimmten Lastprofils (18) und eines elektromechanischen Modells (22) des Produktionssystems (10) mit einer Energieberechnungseinrichtung (20),
    c) Bestimmen eines Energiemodells (36) des Produktionssystems (10) anhand des abgeschätzten Energiebedarfs, wobei zumindest eine der Betriebsgrößen als konstant angenommen wird und in Abhängigkeit von den nicht als konstant angenommenen Betriebsgrößen eine Leistungstabelle bestimmt wird und
    d) Bestimmen des Energieverbrauchs des Produktionssystems (10) mit der Lastberechnungseinrichtung (16) in Abhängigkeit von dem Energiemodell (36) und einer mit dem Produktionssystem (10) transportierten und/oder bearbeiteten Last.

2.  Verfahren nach Anspruch 1, **dadurch gekennzeichnet, dass** das Produktionssystem (10) in einzelne Bereiche (12) unterteilt wird und das Verfahren für jeden der Bereiche (12) durchgeführt wird.

3.  Verfahren nach Anspruch 1 oder 2, **dadurch gekennzeichnet, dass** in Schritt a) das Lastprofil (18) in Abhängigkeit von Betriebsgrößen des Produktionssystems (10), welche eine Geschwindigkeit (v), eine Beschleunigung (a), ein Grundgewicht ($m_0$) des Produktionssystems (10) und/oder ein Gewicht ($m_L$) der Last beschreiben, bestimmt wird.

4.  Verfahren nach einem der vorhergehenden Ansprüche, **dadurch gekennzeichnet, dass** in Schritt b) das elektromechanische Modell (22) in Abhängigkeit von Kenngrößen von Antriebseinrichtungen des Produktionssystems (10) und den Abmessungen des Produktionssystems (10) bestimmt wird.

5.  Verfahren nach einem der vorhergehenden Ansprüche, **dadurch gekennzeichnet, dass** in Schritt c) das Energiemodell (36) in Abhängigkeit von den Betriebsgrößen des Produktionssystems (10) bestimmt wird.

6.  Verfahren nach einem der vorhergehenden Ansprüche, **dadurch gekennzeichnet, dass** zumindest eine der Betriebsgrößen des Produktionssystems (10) anhand von Messungen ermittelt wird.

7.  Verfahren nach Anspruch 1, **dadurch gekennzeichnet, dass** in Schritt d) der Energieverbrauch des Produktionssystems (10) in Abhängigkeit von dem Energiemodell (36) oder der Leistungstabelle bestimmt wird.

8.  Verfahren nach einem der vorhergehenden Ansprüche, **dadurch gekennzeichnet, dass** in Schritt d) zum Bestimmen des Energieverbrauchs zumindest eine der Betriebsgrößen an zumindest zwei aufeinanderfolgende Zeitpunkten untersucht wird.

9.  Verfahren zum Betreiben eines Produktionssystems (10), **dadurch gekennzeichnet, dass** das Produktionssystem (10) in Abhängigkeit von einem mit einem Verfahren nach einem der vorhergehenden Ansprüche bestimmten Energieverbrauch betrieben wird.

**Claims**

1.  Method for determining an energy consumption of a production system (10), comprising the steps of:

    a) determining a load profile (18) of the production system (10) as a function of operating variables of the production system which describe a speed, an acceleration, a basic weight of the production system and/or a weight of the load with the aid of a load-calculating device (16),
    b) estimating an energy requirement of the production system (10) with the aid of an energy-calculating device (20) by using the determined load profile (18) and an electromechanical model (22) of the production system (10),
    c) determining an energy model (36) of the production system (10) by using the estimated energy requirement, wherein at least one of the operating variables is assumed to be constant, and a power table is determined as a function of the operating variables not assumed to be constant, and
    d) determining the energy consumption of the production system (10) with the aid of the load-calculating device (16) as a function of the energy model (36) and a load transported and/or processed with the aid of the production system (10).

2.  Method according to Claim 1, **characterized in that** the production system (10) is subdivided into individual regions (12), and the method is carried out for each of the regions (12).

3.  Method according to Claim 1 or 2, **characterized in that** in step a) the load profile (18) is determined as a function of operating variables of the production system (10) which describe a speed (v), an acceleration (a), a basic weight ($m_0$) of the production system (10) and/or a weight ($m_L$) of the load.

4.  Method according to one of the preceding claims, **characterized in that** in step b) the electromechanical model (22) is determined as a function of parameters of drive devices of the production system (10), and as a function of the dimensions of the production system (10).

5.  Method according to one of the preceding claims, **characterized in that** in step c) the energy model (36) is determined as a function of the operating variables of the production system (10).

**6.** Method according to one of the preceding claims, **characterized in that** at least one of the operating variables of the production system (10) is determined by using measurements.

**7.** Method according to Claim 1, **characterized in that** in step d) the energy consumption of the production system (10) is determined as a function of the energy model (36), or of the power table.

**8.** Method according to one of the preceding claims, **characterized in that** in step d) at least one of the operating variables is examined at at least two consecutive instants in order to determine the energy consumption.

**9.** Method for operating a production system (10), **characterized in that** the production system (10) is operated as a function of an energy consumption determined with the aid of a method according to one of the preceding claims.

**Revendications**

**1.** Procédé pour déterminer une consommation d'énergie d'un système de production (10) comprenant les étapes de :

a) détermination d'un profil de charge (18) du système de production (10) en fonction de grandeurs de fonctionnement du système de production qui décrivent une vitesse, une accélération, un poids de base du système de production et/ou un poids de la charge, par un dispositif de calcul de charge (16),
b) estimation des besoins en énergie du système de production (10) sur la base du profil de charge (18) déterminé et d'un modèle électromécanique (22) du système de production (10), par un dispositif de calcul d'énergie (20),
c) détermination d'un modèle d'énergie (36) du système de production (10) sur la base des besoins en énergie estimés, au moins une des grandeurs de fonctionnement étant présumée constante et un tableau des puissances étant déterminé en fonction des grandeurs de fonctionnement présumées non constantes, et
d) détermination de la consommation d'énergie du système de production (10) par le dispositif de calcul de charge (16) en fonction du modèle d'énergie (36) et d'une charge transportée et/ou travaillée par le système de production (10).

**2.** Procédé selon la revendication 1, **caractérisé en ce que** l'on subdivise le système de production (10) en différentes parties (12) et on met en oeuvre le procédé pour chacune des parties (12).

**3.** Procédé selon la revendication 1 ou 2, **caractérisé en ce que**, à l'étape a), on détermine le profil de charge (18) en fonction de grandeurs de fonctionnement du système de production (10) qui décrivent une vitesse (v), une accélération (a), un poids de base ($m_0$) du système de production (10) et/ou un poids ($m_L$) de la charge.

**4.** Procédé selon l'une des revendications précédentes, **caractérisé en ce que**, à l'étape b), on détermine le modèle électromécanique (22) en fonction de grandeurs caractéristiques de dispositifs d'entraînement du système de production (10) et des dimensions du système de production (10).

**5.** Procédé selon l'une des revendications précédentes, **caractérisé en ce que**, à l'étape c), on détermine le modèle d'énergie (36) en fonction des grandeurs de fonctionnement du système de production (10).

**6.** Procédé selon l'une des revendications précédentes, **caractérisé en ce que** l'on détermine au moins une des grandeurs de fonctionnement du système de production (10) à l'aide de mesures.

**7.** Procédé selon la revendication 1, **caractérisé en ce que**, à l'étape d), on détermine la consommation d'énergie du système de production (10) en fonction du modèle d'énergie (36) ou du tableau des puissances.

**8.** Procédé selon l'une des revendications précédentes, **caractérisé en ce que**, à l'étape d), pour déterminer la consommation d'énergie, on étudie au moins une des grandeurs de fonctionnement à au moins deux instants successifs.

**9.** Procédé pour faire fonctionner un système de production (10), **caractérisé en ce que** l'on fait fonctionner le système de production (10) en fonction d'une consommation d'énergie déterminée par un procédé selon l'une des revendications précédentes.

FIG 1

$v, a, m_0, m_L$

EP 2 825 923 B1

FIG 2

FIG 3

**IN DER BESCHREIBUNG AUFGEFÜHRTE DOKUMENTE**

**In der Beschreibung aufgeführte Patentdokumente**

- DE 29707245 U1

**In der Beschreibung aufgeführte Nicht-Patentliteratur**

- **N. WEINERT.** *Planung energieeffizienter Produktionssysteme,* 2010, 105